# FASCICULE DE BREVET EUROPEEN

(11) **EP 0 908 924 B1**
(45) Date de publication et mention de la délivrance du brevet: **04.06.2003**
(21) Numéro de dépôt: 97203137.1
(22) Date de dépôt: 08.10.1997
(51) Int. Cl.: H01J 37/34

(54) **Dispositif pour la formation d'un revêtement sur un substrat par condensation**
Vorrichtung zur Kondensationserzeugung eines Schichtes auf einem Substrat
Device for the condensation deposition of a film on a substrate

(43) Date de publication de la demande: 14.04.1999
(73) Titulaire: RECHERCHE ET DEVELOPPEMENT DU GROUPE COCKERILL SAMBRE, en abrégé: RD-CS, 4000 Liège (BE)
(72) Inventeur: Vanden Brande, Pierre, 1040 Bruxelles (BE); Weymeersch, Alain, 1300 Wavre (BE)
(74) Mandataire: Callewaert, Jean

(56) Documents cités:
- EP-A- 0 511 153
- EP-A- 0 780 486
- US-A- 5 069 770
- PATENT ABSTRACTS OF JAPAN vol. 014, no. 576 (E-1016), 21 décembre 1990 & JP 02 250325 A (MITSUBISHI ELECTRIC CORP), 8 octobre 1990,
- DATABASE WPI Section Ch, Week 9501 Derwent Publications Ltd., London, GB; Class L03, AN 95-002562 XP002056941 & JP 06 291 063 A (TOKYO ELECTRON YAMANASHI LTD) , 18 octobre 1994
- PATENT ABSTRACTS OF JAPAN vol. 013, no. 466 (C-646), 20 octobre 1989 & JP 01 180981 A (SANYO ELECTRIC CO LTD), 18 juillet 1989,
- DATABASE WPI Section Ch, Week 9116 Derwent Publications Ltd., London, GB; Class L03, AN 91-110168 XP002056942 & DD 284 486 A (VEB HOCHVAK DRESDEN) , 14 novembre 1990

## Description

La présente invention est relative à un dispositif pour la formation d'un revêtement sur un substrat par condensation d'un élément, notamment d'un métal, sur ce substrat, comprenant (a) une enceinte où a lieu une évaporation et/ou pulvérisation cathodique dudit élément et dans laquelle est agencée une cible présentant au moins une couche superficielle contenant l'élément susdit et orientée vers le substrat se trouvant en regard et au-dessus de la cible, (b) des moyens pour évaporer ledit élément et/ou (c) des moyens pour réaliser la pulvérisation cathodique de l'élément susdit à partir de la cible vers le substrat.

Un des problèmes qui se pose avec les dispositif connus du type précité est que les parois de l'enceinte, où ont lieu l'évaporation et/ou la pulvérisation cathodique, se contaminent par l'élément dont le revêtement doit être formé. Ceci influence non seulement le bon fonctionnement du dispositif, nécessitant des nettoyages répétés de ces parois, mais provoque également une perte non négligeable en matière à déposer sur le substrat (v. par exemple PATENTS ABSTRACTS OF JAPAN, vol. 014, n^{o} 576 (E-1016), 21 décembre 1990, abrégé de JP-A-02 250 325, où les parois latérales de l'enceinte polarisées négativement sont nettoyées par érosion ionique).

Ainsi, un des buts essentiels de la présente invention est de diminuer et même de supprimer la contamination de ces parois.

A cet effet, suivant l'invention, le dispositif comprend une paroi électriquement conductrice délimitant latéralement l'espace entre la cible et le substrat et des moyens pour polariser négativement ou positivement cette paroi par rapport au substrat, ladite paroi conductrice polarisée négativement ou positivement se réchauffe sous le bombardement d'ions positifs ou électrons présentant une température à laquelle une vapeur de l'élément susdit provenant de la cible ne peut pas se condenser sur elle.

Avantageusement, une isolation thermique est prévue du côté de la paroi conductrice susdite opposé à celui dirigé vers l'espace entre la cible et le substrat.

Dans une forme de réalisation particulière de l'invention, un circuit magnétique est prévu du côté de la paroi conductrice susdite opposé à celui dirigé vers l'espace précité.

D'autres détails et particularités de l'invention ressortiront de la description, donnée ci-après, à titre d'exemple non limitatif, de quelques formes de réalisation particulières de l'invention avec référence aux dessins annexés.
La figure 1 est une vue schématique partielle et en coupe verticale d'une première forme de réalisation d'un dispositif pour le revêtement de substrat se présentant sous forme d'une bande continue.
La figure 2 est une vue schématique analogue à celle de la figure 1 destinée au traitement de substrats fixes montés à l'intérieur de l'enceinte.
La figure 3 est.une coupe suivant la ligne III-III de la figure 2.
La figure 4 est une vue schématique en élévation d'une troisième forme de réalisation d'un dispositif suivant l'invention avec une cathode pivotante.
La figure 5 est une coupe suivant la ligne V-V de la figure 4.

Dans les différentes figures, les mêmes chiffres de référence se rapportent à des mesures technologiques analogues ou identiques.

D'une façon générale, la présente invention est relative à un dispositif pouvant être utilisé pour la formation d'un revêtement sur un substrat de forme quelconque par condensation d'un élément, notamment d'un métal, sur ce substrat.

Ce dispositif comprend une enceinte ou chambre sous vide, où a lieu une évaporation et/ou une pulvérisation cathodique de cet élément, dans laquelle est agencée une cible. Cette dernière présente une couche superficielle orientée vers le substrat et contenant l'élément susdit. Des moyens sont prévus pour évaporer cet élément et/ou pour réaliser la pulvérisation cathodique de celui-ci à partir de la cible vers le substrat.

Suivant l'invention, ce dispositif est caractérisé par le fait qu'il comprend une paroi conductrice entourant l'espace entre la cible et le substrat et des moyens pour polariser négativement ou positivement cette paroi par rapport à ce dernier.

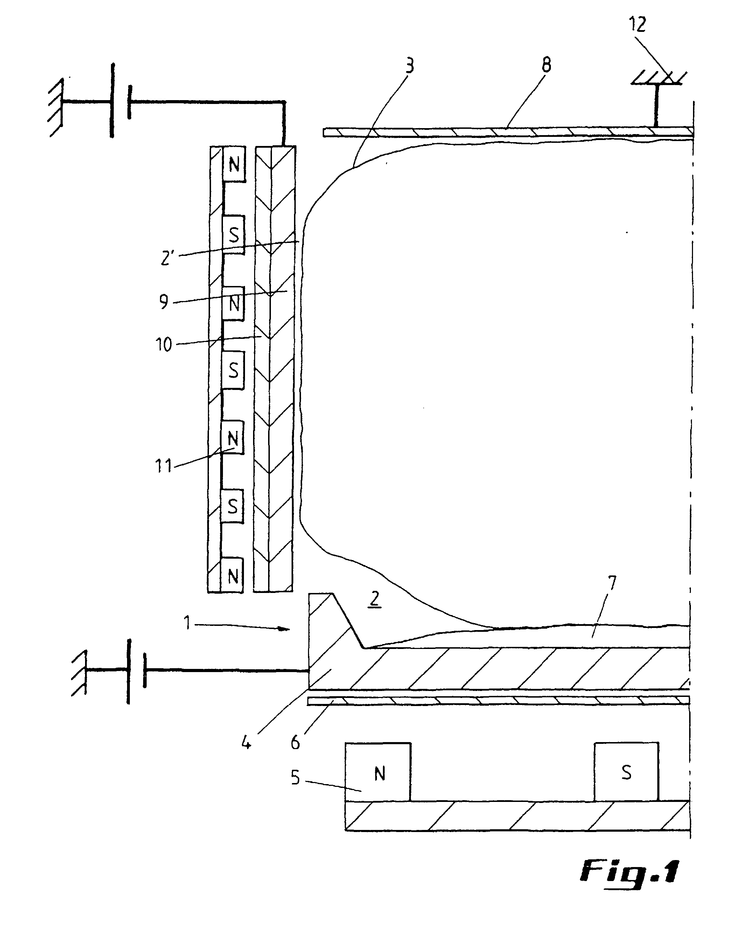

Ainsi, la figure 1, qui montre une première réalisation d'un dispositif suivant l'invention, comprend, d'une part, un évaporateur-pulvérisateur cathodique 1 et, d'autre part, une chambre ou enceinte sous vide 2 dans laquelle peut être généré un plasma 3.

L'évaporateur-pulvérisateur cathodique 1 est essentiellement constitué par un creuset 4, en dessous duquel est agencé un circuit magnétique 5 séparé de ce creuset par une isolation thermique 6.

Le creuset 4 contient l'élément, généralement constitué d'un métal, à pulvériser, évaporer ou sublimer.

La chambre sous vide est délimitée à sa partie supérieure, en regard du creuset 4, par une bande continue de tôle formant le substrat 8 et se déplaçant suivant une direction perpendiculaire au plan du dessin. Ce creuset 4 contient une couche de métal 7 et formant la cible précitée.

L'espace 2' de cette chambre 2 ménagé entre le substrat 8 et le creuset 4 est délimité latéralement par une paroi conductrice 9.

Cette paroi 9 est polarisée électriquement, par exemple négativement ou positivement par rapport au substrat.

Par ailleurs, pour permettre la pulvérisation cathodique, le métal 7 contenu dans le creuset 4 est maintenu à un potentiel négatif par rapport au substrat 1 et le plasma 3 est créé à proximité de ce métal éventuellement liquide 7 grâce à la présence du circuit magnétique 5.

Un gaz inerte, tel que de l'argon, est éventuellement introduit dans la chambre sous vide 2 par des injecteurs, non représentés, dirigés de préférence en oblique vers le plasma 3 et vers le métal liquide 7.

De cette façon, ce gaz inerte est ionisé et les ions ainsi formés bombardent la surface du métal 7 en éjectant des particules de ce dernier vers le substrat 8.

Le document EP-A-95870065.6 décrit un procédé de pulvérisation cathodique qui est applicable dans le cadre de la présente invention moyennant un réglage approprié de la température du creuset 4 pour obtenir la tension de vapeur requise du métal précité au-dessus du creuset, comme décrit dans le document EP-A-962031211.6. Dans ce cas, l'injection d'argon n'est pas toujours indispensable.

Ainsi, la paroi conductrice 9 se réchauffe sous le bombardement d'ions positifs ou d'électrons contenus dans le plasma 3.

Lorsque la température de la paroi 9 est devenue suffisamment élevée, la vapeur métallique provenant de la cible 7 ne peut plus se condenser, de sorte que la contamination de cette paroi 9 devient très réduite et pratiquement inexistante.

Le choix de la matière de la paroi 9 à un matériau de faible tension de vapeur et à très faible rendement de pulvérisation cathodique, dans le cas où elle est polarisée négativement, réduit ou évite la contamination du dépôt en formation sur le substrat.

Un tel matériau peut, par exemple, être du graphite, du tantale, du tungstène ou une céramique conductrice d'électricité.

De plus, pour éviter des pertes thermiques dans la chambre sous vide 2 et ainsi de limiter la consommation énergétique, la paroi conductrice 9 peut être pourvue, à son côté extérieur, d'une isolation thermique 10.

Un circuit magnétique 11 est également agencé derrière la paroi conductrice 9, qui n'est toutefois pas indispensable

Dans un cas particulier, la paroi conductrice 9 peut être maintenue sensiblement au même potentiel que la cible de métal liquide 7, tandis que le substrat 8 peut être mis à la masse 12.

Enfin, comme déjà décrit dans le document EP-A-962031211.6, des moyens de régulation thermiques, non représentés, sont avantageusement prévus pour maintenir la couche superficielle de la cible 8 à l'état liquide.

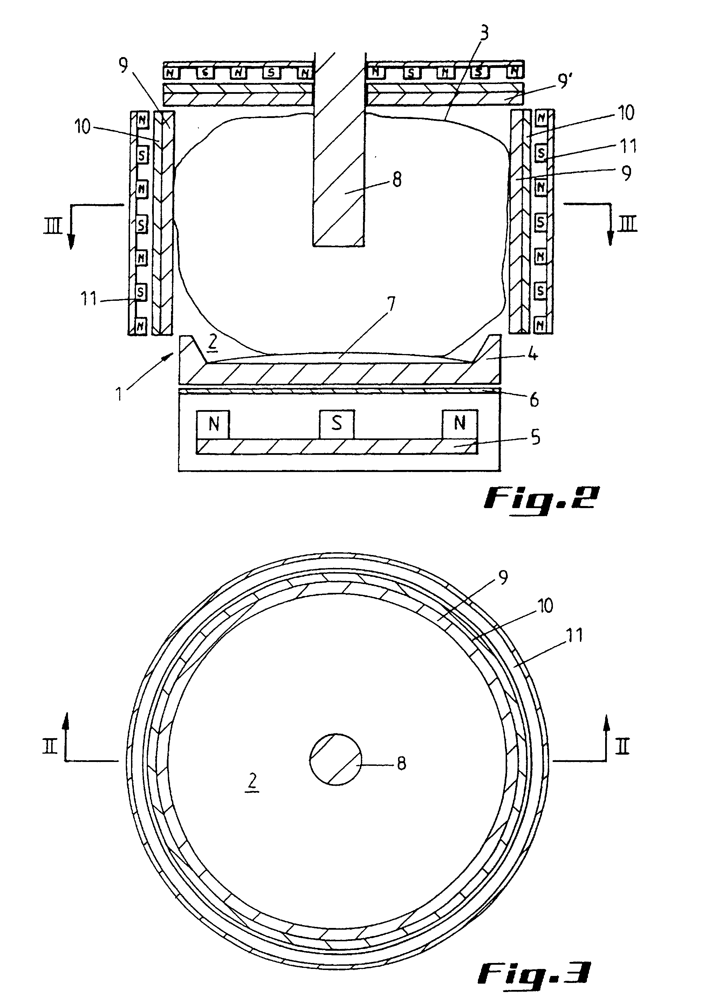

La forme de réalisation représentée aux figures 2 et 3 se différencie par rapport à celle montrée à la figure 1 par le fait qu'elle concerne un dispositif pour la formation d'un revêtement sur la surface extérieure d'un objet 8 suspendu dans la chambre sous vide 2. Cet objet correspond donc au substrat, dont il est question ci-dessus.

Dans cette forme de réalisation, la paroi conductrice 9 comprend une partie 9' s'étendant du côté en regard du creuset 4, autour de l'objet 8 à revêtir par évaporation-pulvérisation cathodique.

Cette partie 9' remplit la même fonction que la paroi 9 s'étendant latéralement autour de l'espace situé au-dessus du creuset 4.

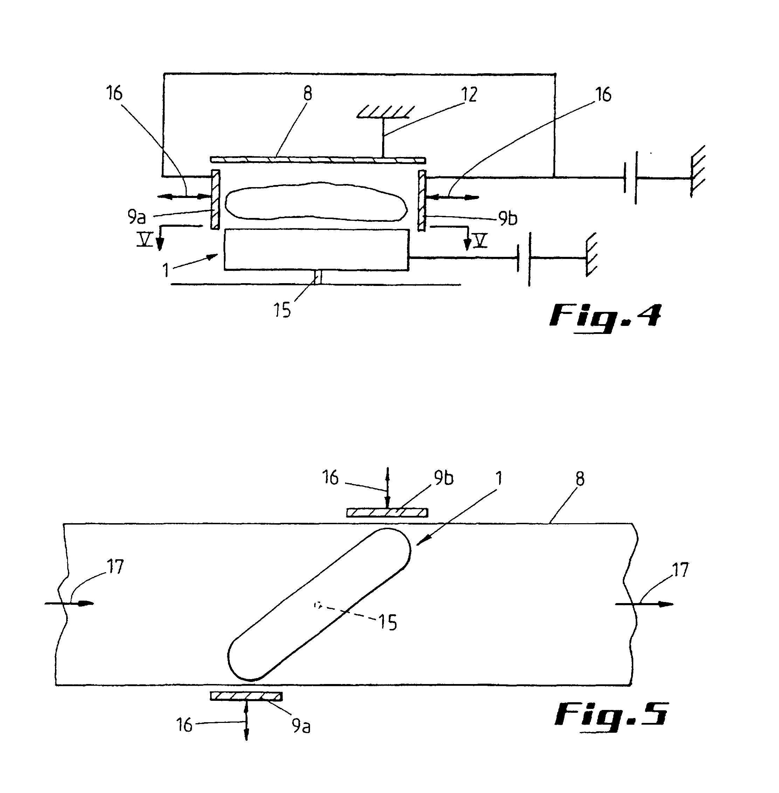

Les figures 4 et 5 concernent une troisième forme de réalisation du dispositif, suivant l'invention, qui se distingue par rapport aux précédentes par le fait que l'on fait usage, d'une part, d'un creuset 4 pivotant sur un axe vertical 15 et, d'autre part, de deux paroi opposées conductrices 9a et 9b mobiles suivant la direction des flèches 16 et éventuellement également suivant une direction parallèle à leur plan.

Cette forme de réalisation convient particulièrement pour le revêtement de substrats 5 formés par des bandes continues de différentes largeurs se déplaçant dans le sens des flèches 17.

En effet, en pivotant le creuset 4 autour de l'axe 15, et en déplaçant en même temps les parois conductrices 9a et 9b pour qu'elles soient toujours le plus proche possible de ce creuset 4, on peut adapter très facilement la zone d'évaporation-pulvérisation cathodique à la largeur du substrat 8 à couvrir.

Le dispositif, suivant l'invention, peut avantageusement être appliqué pour recouvrir des substrats par du zinc, du magnésium, de l'étain, du manganèse, du chrome, ou un alliage de ces métaux.

Typiquement, la paroi conductrice 9 est maintenue à un potentiel de -500 Volts, alors que la densité de puissance peut généralement varier de 1 Watt par cm² à 100 Watts par cm².

## Revendications

1. Dispositif pour la formation d'un revêtement sur un substrat (8) par condensation d'un élément, notamment d'un métal, sur ce substrat (8), comprenant une enceinte (2) où a lieu une pulvérisation cathodique dudit élément ainsi qu'éventuellement simultanément une évaporation de celui-ci et dans laquelle est agencée une cible (7) présentant au moins une couche superficielle contenant l'élément susdit et orientée vers le substrat (8) se trouvant en regard et au-dessus de la cible (7), et des moyens pour réaliser la pulvérisation cathodique de l'élément susdit à partir de la cible (7) vers le substrat (8), ainsi qu'éventuellement des moyens pour évaporer simultanément ledit élément, ce dispositif étant **caractérisé en ce qu'**il comprend une paroi électriquement conductrice (9, 9a, 9b) délimitant au moins latéralement l'espace (2') entre la cible (7) et le substrat (8), et des moyens pour polariser négativement ou positivement cette paroi (9, 9a, 9b) par rapport au substrat (8) et **en ce que** ladite paroi conductrice (9, 9a, 9b) polarisée négativement ou positivement se réchauffe sous le bombardement d'ions positifs ou d'electrons et présente une température à laquelle une vapeur de l'élément susdit provenant de la cible ne peut pas se condenser sur elle.

2. Dispositif suivant la revendication 1, **caractérisé en ce qu'**une isolation thermique (6) est prévue du côté de la paroi conductrice (9) susdite opposé à celui dirigé vers l'espace (2') entre la cible (7) et le substrat (8).

3. Dispositif suivant l'une ou l'autre des revendications 1 et 2, **caractérisé en ce qu'**un circuit magnétique (11) est prévu du côté de la paroi conductrice (9, 9a, 9b) susdite opposé à celui dirigé vers l'espace (2') précité.

4. Dispositif suivant l'une quelconque des revendications 1 à 3, **caractérisé en ce que** la paroi (9, 9a, 9b) précitée est constituée d'un matériau conducteur à faible rendement de pulvérisation et à faible tension de vapeur, tel que du graphite.

5. Dispositif suivant l'une quelconque des revendications 1 à 4, **caractérisé en ce que** des moyens sont prévus pour mettre la paroi (9, 9a, 9b) sensiblement au même potentiel que la cible (7).

6. Dispositif suivant l'une quelconque des revendications 1 à 5, **caractérisé en ce que** des moyens sont prévus pour mettre le substrat (8) à la masse.

7. Dispositif suivant l'une quelconque des revendications 1 à 6, **caractérisé en ce que** des moyens de régulation thermique sont prévus pour maintenir au moins ladite couche superficielle de la cible (7) à l'état liquide.

8. Dispositif suivant l'une quelconque des revendications 1 à 7, **caractérisé en ce qu'**il comprend un circuit magnétique (5) refroidi du côté de la cible (7) opposé à celui orienté vers le substrat (8).

9. Dispositif suivant l'une quelconque des revendications 1 à 8, **caractérisé en ce que** la cible (7) est à un potentiel négatif par rapport au substrat et **en ce que** lesdits moyens pour réaliser la pulvérisation cathodique créent entre la cible et le substrat un plasma contenant des ions positifs ou des électrons qui, par bombardement de ladite paroi conductrice, maintiennent celle-ci à ladite température à laquelle une vapeur de l'élément susdit provenant de la cible ne peut pas condenser sur elle.

## Patentansprüche

1. Vorrichtung zur Bildung einer Beschichtung auf einem Substrat (8) durch Kondensation eines Elements, insbesondere eines Metalls, auf diesem Substrat (8), umfassend einen Raum (2), wo eine Kathodenzerstäubung des Elements sowie eventuell gleichzeitig eine Verdampfung desselben stattfindet und in welchem ein Target (7) angeordnet ist, das mindestens eine Oberflächenschicht aufweist, welche das vorstehend genannte Element enthält und gegen das sich gegenüber und oberhalb des Targets (7) befindliche Substrat (8) gerichtet ist, und Mittel zum Durchführen der Kathodenzerstäubung des vorstehend genannten Elements von dem Target (7) aus gegen das Substrat (8), sowie eventuell Mittel zum gleichzeitigen Verdampfen des Elements, wobei diese Vorrichtung **dadurch gekennzeichnet ist, daß** sie eine elektrisch leitende Wand (9, 9a, 9b) umfaßt, die zumindest seitlich den Raum (2') zwischen dem Target (7) und dem Substrat (8) begrenzt, und Mittel, um diese Wand (9, 9a, 9b) in Bezug auf das Substrat (8) negativ oder positiv zu polarisieren, und dadurch, daß die negativ oder positiv polarisierte leitende Wand (9, 9a, 9b) sich unter dem Bombardement von positiven Ionen oder von Elektronen erwärmt und eine Temperatur aufweist, bei welcher ein von dem Target kommender Dampf des vorstehend genannten Elements nicht auf derselben kondensieren kann.

2. Vorrichtung nach Anspruch 1, **dadurch gekennzeichnet, daß** eine thermische Isolation (6) auf der Seite der vorstehend genannten leitenden Wand (9) vorgesehen ist, die derjenigen, welche gegen den Raum (2') zwischen dem Target (7) und dem Substrat (8) gerichtet ist, entgegengesetzt ist.

3. Vorrichtung nach einem der Ansprüche 1 oder 2, **dadurch gekennzeichnet, daß** ein Magnetkreis (11) auf der Seite der vorstehend genannten leitenden Wand (9, 9a, 9b) vorgesehen ist, die derjenigen, welche gegen den vorstehend genannten Raum (2') gerichtet ist, entgegengesetzt ist.

4. Vorrichtung nach einem der Ansprüche 1 bis 3, **dadurch gekennzeichnet, daß** die vorstehend genannte Wand (9, 9a, 9b) aus einem leitenden Material mit niedriger Zerstäubungsausbeute und mit niedrigem Dampfdruck, wie beispielsweise Graphit, gebildet ist.

5. Vorrichtung nach einem der Ansprüche 1 bis 4, **dadurch gekennzeichnet, daß** Mittel vorgesehen sind, um die Wand (9, 9a, 9b) im wesentlichen auf dasselbe Potential wie das Target (7) zu legen.

6. Vorrichtung nach einem der Ansprüche 1 bis 5, **dadurch gekennzeichnet, daß** Mittel vorgesehen sind, um das Substrat (8) auf Masse zu legen.

7. Vorrichtung nach einem der Ansprüche 1 bis 6, **dadurch gekennzeichnet, daß** Mittel zur thermischen Regulierung vorgesehen sind, um zumindest die Oberflächenschicht des Targets (7) im flüssigen Zustand zu halten.

8. Vorrichtung nach einem der Ansprüche 1 bis 7, **dadurch gekennzeichnet, daß** sie einen gekühlten Magnetkreis (5) auf der Seite des Targets (7), die derjenigen, die gegen das Substrat (8) gerichtet ist, entgegengesetzt ist, umfaßt.

9. Vorrichtung nach einem der Ansprüche 1 bis 8, **dadurch gekennzeichnet, daß** das Target (7) auf einem in Bezug auf das Substrat negativen Potential liegt und dadurch, daß die Mittel zum Durchführen der Kathodenzerstäubung zwischen dem Target und dem Substrat ein Plasma erzeugen, das positive Ionen oder Elektronen enthält, welche, durch Bombardement der leitenden Wand, dieselbe auf der Temperatur halten, bei der ein von dem Target kommender Dampf des vorstehend genannten Elements nicht auf derselben kondensieren kann.

## Claims

1. Device for forming a coating on a substrate (8) by condensing an element, especially a metal, on this substrate (8), comprising an enclosure (2) in which a cathodic sputtering of the said element as well as optionally simultaneously an evaporation thereof take place and in which a target (7) is arranged, the said target having at least one surface layer containing the abovementioned element and turned towards the substrate (8) which lies facing and above the target (7), and means for sputtering the abovementioned element from the target (7) onto the substrate (8), as well as optionally means for simultaneously evaporating the said element, this device being **characterized in that** it comprises an electrically conductive wall (9, 9a, 9b) defining, at least laterally, the space (2') between the target (7) and the substrate (8), and means for biasing this wall (9, 9a, 9b) negatively or positively with respect to the substrate (8) and in which the said negatively or positively biased conductive wall (9, 9a, 9b) is heated under a bombardment by electrons or positive ions and has a temperature at which a vapour of the said element coming from the target can not condensate thereon.

2. Device according to Claim 1, **characterized in that** thermal insulation (6) is provided on that side of the abovementioned conductive wall (9) which is opposite the side facing the space (2') between the target (7) and the substrate (8).

3. Device according to either of Claims 1 and 2, **characterized in that** a magnetic circuit (11) is provided on that side of the abovementioned conductive wall (9, 9a, 9b) which is opposite the side facing the aforementioned space (2').

4. Device according to any one of Claims 1 to 3, **characterized in that** the aforementioned wall (9, 9a, 9b) is made of a conductive material having a low sputtering yield and a low vapour pressure, such as graphite.

5. Device according to any one of Claims 1 to 4, **characterized in that** means are provided for setting the wall (9, 9a, 9b) at substantially the same potential as the target (7).

6. Device according to any one of Claims 1 to 5, **characterized in that** means are provided for earthing the substrate (8).

7. Device according to any one of Claims 1 to 6, **characterized in that** thermal regulation means are provided in order to maintain at least the said surface layer of the target (7) in the liquide stade.

8. Device according to any one of Claims 1 to 7, **characterized in that** it comprises a magnetic circuit (5) which is cooled on that side of ther target (7) which is opposite that facing the substrate (8).

9. Device according to any one of Claims 1 to 8, **characterized in that** the target (7) is at a negative potential with respect to the substrate and said means for cathodic sputtering create between the target and the substrate a plasma containing positive ions or electrons which, by bombardment of said conductive wall, maintain this wall at said temperature at which a vapour of the said element coming from the target can not condensate thereon.
